# EUROPEAN PATENT SPECIFICATION

(11) **EP 3 306 676 B1**
(45) Date of publication and mention of the grant of the patent: **25.03.2020**
(21) Application number: 16799604.0
(22) Date of filing: 05.02.2016
(51) Int. Cl.: H01L 31/054, H02S 20/32

(54) **CONCENTRATOR PHOTOVOLTAIC MODULE, CONCENTRATOR PHOTOVOLTAIC PANEL, AND CONCENTRATOR PHOTOVOLTAIC DEVICE**
KONZENTRATOR-PHOTOVOLTAIKMODUL, KONZENTRATOR-PHOTOVOLTAIKPANEEL UND KONZENTRATOR-PHOTOVOLTAIKVORRICHTUNG
MODULE PHOTOVOLTAÏQUE À CONCENTRATEUR, PANNEAU PHOTOVOLTAÏQUE À CONCENTRATEUR ET DISPOSITIF PHOTOVOLTAÏQUE À CONCENTRATEUR

(30) Priority: 25.05.2015 JP 2015105408
(43) Date of publication of application: 11.04.2018
(73) Proprietor: Sumitomo Electric Industries, Ltd., Osaka-shi, Osaka 541-0041 (JP)
(72) Inventor: SAITO, Kenji, Osaka-shi Osaka 554-0024 (JP); INAGAKI, Makoto, Osaka-shi Osaka 554-0024 (JP); ABIKO, Yoshiya, Osaka-shi Osaka 554-0024 (JP); TOYA, Kazumasa, Osaka-shi Osaka 554-0024 (JP)
(74) Representative: Boult Wade Tennant LLP
(86) International application number: PCT/JP2016/053523
(87) International publication number: WO 2016/189895

(56) References cited:
- WO-A1-2009/066720
- WO-A1-2013/098426
- JP-A- 2000 091 612
- JP-A- 2000 091 612
- US-A- 6 020 554
- US-A1- 2009 260 674
- US-A1- 2014 251 413

## Description

### TECHNICAL FIELD

The present invention relates to a concentrator photovoltaic (CPV) module, a CPV panel, and a CPV apparatus which generate power by concentrating sunlight on cells.

### BACKGROUND ART

In a concentrator photovoltaic apparatus, a basic unit structure is employed in which: a small-sized compound semiconductor element having high power generation efficiency is used as a power generating element; and sunlight concentrated by a Fresnel lens is caused to be incident on the power generating element.

A large number of such basic units are arranged in a matrix shape in one housing, thereby to form a concentrator photovoltaic module. A plurality of the modules are further arranged, thereby to form a concentrator photovoltaic panel.

The concentrator photovoltaic apparatus includes a driving device for causing the concentrator photovoltaic panel to perform tracking operation such that the concentrator photovoltaic panel always faces the sun.

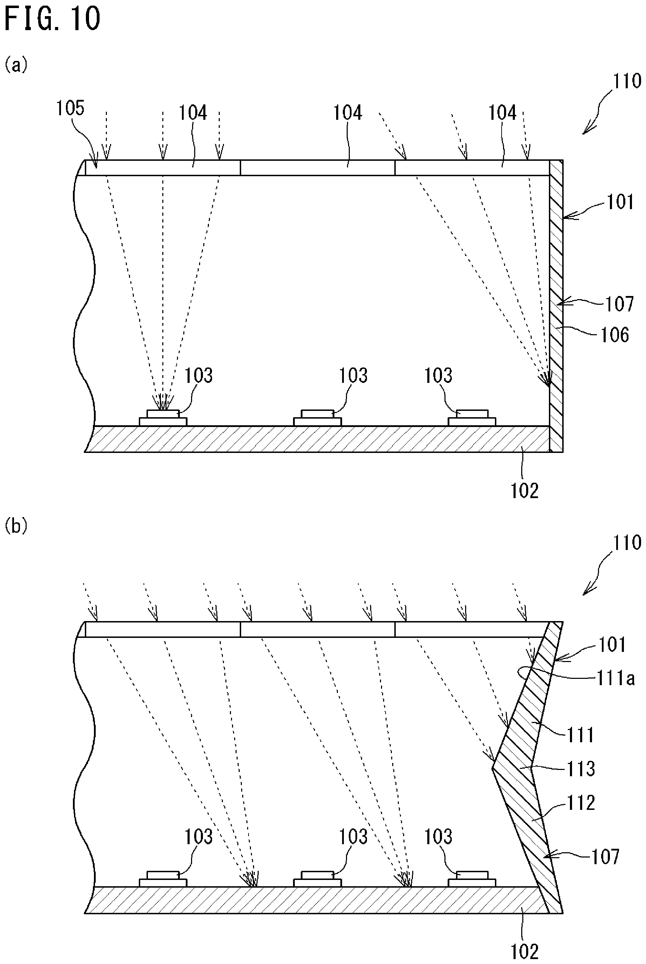

FIG. 10(a) is a partial cross-sectional view of a concentrator photovoltaic module.

A concentrator photovoltaic module 110 includes: a housing 101; a plurality of power generating elements 103 provided on a bottom plate 102 of the housing 101; and a plate-shaped concentrating member 105 in which a plurality of Fresnel lenses 104 for concentrating sunlight are formed.

The housing 101 includes a rectangular-shaped frame 107 formed by side wall plates 106 which are provided so as to stand along the outer edge of the bottom plate 102.

In FIG. 10(a), with respect to the leftmost Fresnel lens 104 on the drawing sheet, the paths of rays at the time when sunlight is orthogonally incident onto the Fresnel lens 104 are indicated by broken lines, and with respect to the rightmost Fresnel lens 104 on the drawing sheet, the paths of rays at the time when sunlight is incident from a direction inclined relative to the normal direction of the Fresnel lens 104 are indicated by broken lines.

Each power generating element 103 is disposed near the focal point position of its corresponding Fresnel lens 104. Accordingly, when sunlight is orthogonally incident onto the Fresnel lens 104, sunlight is concentrated on the power generating element 103.

Thus, the driving device performs tracking operation such that sunlight is always orthogonal to modules 110.

Here, for example, if the driving device has stopped due to some cause and thus sunlight is incident from a direction inclined relative to the normal direction of the Fresnel lens 104, the ray axis of sunlight having passed through the Fresnel lens 104 also becomes inclined, thus causing positional displacement in the sunlight-concentrated part. Thus, sunlight is not concentrated on the power generating element 103 but is concentrated on another part in the housing 101.

In particular, there are cases where sunlight having passed through the Fresnel lens 104 that is disposed near a side wall plate 16 is concentrated toward the side wall plate 16 as shown in FIG. 10(a).

There are cases where the frame 107 is formed from resin or the like in order to reduce the weight and cost of the frame 107.

In a case where the frame 107 is formed from resin, when concentrated sunlight is applied on the inner side-surface of the frame 107, the frame 107 may be damaged by its inner side-surface being scorched or the like.

Thus, in order to prevent damage of the inner side-surface of the frame 107, there are cases where the frame 107 is shaped by combining frame bodies 111 and 112 each having a truncated quadrangular pyramid shape as shown in FIG. 10(b). In FIG. 10(b), the paths of rays at the time when sunlight is incident from a direction inclined relative to the normal direction of the Fresnel lenses 104 are indicated by broken lines.

The frame 107 has a shape obtained by bringing the end surfaces of the frame bodies 111 and 112 into contact with each other, on the side where the area of the region surrounded by the outer edge of the frame body 111, 112 is smaller. Accordingly, a connection portion 113 between the frame bodies 111 and 112 is caused to project inward from the housing 101, and when the ray axis of sunlight becomes inclined and the sunlight-concentrated part is displaced to be outside of the power generating element 103, sunlight is applied to an inner inclined surface 111a of the frame body 111.

In this case, even when the ray axis of sunlight is inclined and the sunlight is applied toward the inner side-surface of the frame 107, the sunlight is applied to the inner inclined surface 111a which is located nearer to the Fresnel lens 104 than the focal point of the Fresnel lens 104 is. Thus, the sunlight is applied to the inner inclined surface 111a before being sufficiently concentrated, and thus the damage can be prevented (see PATENT LITERATURE 1, for example). An example of a concentrator photovoltaic module comprising a light shield to prevent damage to the side wall of the housing is known from US 6 020 554 A.

### CITATION LIST

### [PATENT LITERATURE]

PATENT LITERATURE 1: International Publication No. WO2013/098426 A1

### SUMMARY OF INVENTION

### [TECHNICAL PROBLEM]

However, in the conventional concentrator photovoltaic module described above, the frame 107 has a complicated shape obtained by combining a pair of the frame bodies 111 and 112 each having a truncated quadrangular pyramid shape, and thus, the die for forming the frame 107 from resin cannot help employing the complicated structure.

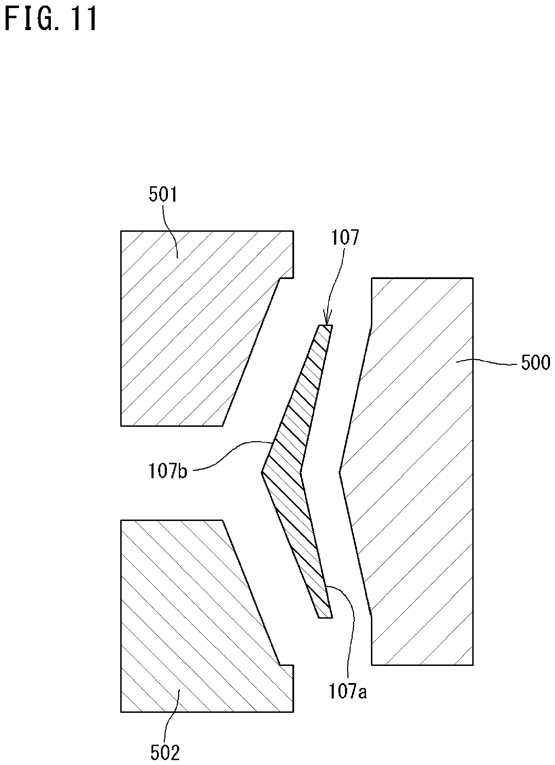

FIG. 11 shows a configuration of a die for forming the frame 107 of the conventional concentrator photovoltaic module described above.

The die shown in FIG. 11 includes: a first die 500 for forming an outer side-surface 107a side of the frame 107; a second die 501 for forming an inner side-surface 107b side; and a third die 502 for forming the inner side-surface 107b side. Since the shape of the frame 107 cannot be formed by a die that is to be pulled out in two directions, the die is configured so as to be pulled out in four directions, in which the second die 501 and the third die 502 are pulled out in directions orthogonal to the direction in which the first die 500 is pulled out.

In the above conventional example, by employing such a die that is to be pulled out in four directions, the size of the entirety of the die is increased in order to ensure the movement stroke for each die. This increases costs of the die and of a pressing apparatus or the like in which to set the die.

Thus, the conventional concentrator photovoltaic module described above cannot help employing a complicated structure for the die for forming the frame 107 from resin. This could cause increased production cost for the frame 107.

The present invention has been made in view of such circumstances. An object of the present invention is to provide a concentrator photovoltaic module, a concentrator photovoltaic panel, and a concentrator photovoltaic apparatus that can realize low cost and that can prevent damage of the housing even when positional displacement has occurred in the sunlight-concentrated part.

### [SOLUTION TO PROBLEM]

A concentrator photovoltaic module according to the invention is defined in claim 1 and includes: a housing having an open face on one face thereof; a plurality of power generating elements provided in a form of an array on a bottom plate of the housing; and a concentrating member being mounted on the housing so as to cover the open face, being disposed so as to face the bottom plate, and being composed of a plurality of condenser lenses for concentrating sunlight, the condenser lenses formed at positions corresponding to the power generating elements on respective optical axes of the condenser lenses. In the concentrator photovoltaic module, the housing includes a frame composed of a resin side wall plate provided so as to stand along an outer edge of the bottom plate, and inward from the frame, a shielding plate configured to block sunlight concentrated by the condenser lenses from being applied to an inner side-surface of the side wall plate is provided so as to project inward relative to the inner side-surface.

A concentrator photovoltaic panel according to the invention is defined in claim 5 and is formed by arranging a plurality of the above concentrator photovoltaic modules.

A concentrator photovoltaic apparatus according to the invention is defined in claim 6 and includes: the above concentrator photovoltaic panel; and a driving device configured to drive the concentrator photovoltaic panel so as to operate to track movement of the sun while facing the direction of the sun.

### [ADVANTAGEOUS EFFECTS OF INVENTION]

According to the present invention, it is possible to realize low cost and to prevent damage of the housing even when positional displacement has occurred in the sunlight-concentrated part.

### BRIEF DESCRIPTION OF DRAWINGS

[FIG. 1] FIG. 1 is a perspective view showing one example of a concentrator photovoltaic apparatus.
[FIG. 2] FIG. 2 shows one example of a concentrator photovoltaic system including a driving device and the like.
[FIG. 3] FIG. 3 is a perspective view (partially cut out) showing an enlarged view of one example a concentrator photovoltaic module.
[FIG. 4] FIG. 4 is a cross-sectional view of a main portion of the concentrator photovoltaic module.
[FIG. 5] FIG. 5 is a cross-sectional view of the module when sunlight is incident from a direction inclined relative to the normal direction of each Fresnel lens.
[FIG. 6] FIG. 6 is a cross-sectional view of a main portion of a plurality of frames having been stacked.
[FIG. 7] FIG. 7 is a cross-sectional view of a main portion of a concentrator photovoltaic module according to another embodiment.
[FIG. 8] FIG. 8(a) is a cross-sectional view of a main portion of a concentrator photovoltaic module according to a modification, and FIG. 8(b) shows only shielding plates at the time when the concentrator photovoltaic module shown in FIG. 8(a) is viewed from an open face side.
[FIG. 9] FIG. 9(a) shows a modification of the shielding plate, FIG. 9(b) shows another modification of the shielding plate, and FIG. 9(c) shows still another modification of the shielding plate.
[FIG. 10] FIG. 10(a) is a partial cross-sectional view of a conventional concentrator photovoltaic module, and FIG. 10(b) is a partial cross-sectional view of another conventional concentrator photovoltaic module.
[FIG. 11] FIG. 11 shows a configuration of a die for forming a frame of a conventional concentrator photovoltaic module.

### DESCRIPTION OF EMBODIMENTS

### [Description of embodiments of the present invention]

First, contents of embodiments will be listed for description.
(1) A concentrator photovoltaic module being one embodiment includes: a housing having an open face on one face thereof; a plurality of power generating elements provided in a form of an array on a bottom plate of the housing; and a concentrating member being mounted on the housing so as to cover the open face, being disposed so as to face the bottom plate, and being composed of a plurality of condenser lenses for concentrating sunlight, the condenser lenses formed at positions corresponding to the power generating elements on respective optical axes of the condenser lenses. In the concentrator photovoltaic module, the housing includes a frame composed of a resin side wall plate provided so as to stand along an outer edge of the bottom plate, and inward from the frame, a shielding plate configured to block sunlight concentrated by the condenser lenses from being applied to an inner side-surface of the side wall plate is provided so as to project inward relative to the inner side-surface.
   According to the concentrator photovoltaic module having the above configuration, the shielding plate configured to block sunlight from being applied to the inner side-surface of the side wall plate is provided so as to project inward relative to the inner side-surface. Therefore, unlike the conventional example described above, in order to block sunlight, the frame need not be formed in a complicated shape obtained by bringing a pair of frame bodies each having a truncated quadrangular pyramid shape into contact with each other. Therefore, the frame can have a shape that can simplify the structure of the die for forming the frame. As a result, it is possible to suppress production cost of the frame, and it is possible to realize low cost and to prevent damage of the housing even when positional displacement has occurred in the sunlight-concentrated part.
(2) In the above concentrator photovoltaic module, the shielding plate is coupled to the side wall plate by a support portion provided so as to protrude from the inner side-surface, and is formed integrally with the support portion and the side wall plate. The shielding plate is formed at the same time as the frame is formed.
(3) In the above concentrator photovoltaic module, in a case where the frame includes: a first frame body whose one end forms the open face; and a second frame body being on the bottom plate side and being connected to another end of the first frame body, the first frame body may be formed to have dimensions that allow the second frame body to be inserted inside the first frame body, and when a second frame body forming another frame is inserted into the first frame body, the support portion may abut against the second frame body forming the another frame to hold the another frame in a height direction of the frame.
   In a case where there are a plurality of the frames configured as described above, by inserting, into the first frame body of one frame, the second frame body of another frame up to a position where the second frame body abuts against the support portion, the one frame and the another frame can be combined with each other. Thus, by inserting portions of the plurality of frames into one another, the plurality of frames can be combined with one another and can be sequentially stacked with one another. When compared with a case where frames that cannot be combined by inserting a portion thereof into another frame are stacked, the space occupied by the stacked frames can be reduced.
   As a result, when producing the concentrator photovoltaic module, it is possible to reduce the space necessary for storage and transportation of a large number of frames, and further, it is possible to reduce costs.
(4) Further, a positioning portion configured to position a tip portion of the second frame body of the another frame may be formed in the support portion. In this case, positional displacement between the frames combined with each other can be prevented, and thus, the frames can be combined stably.
(5) The above concentrator photovoltaic module may further include a rib being disposed in the housing and standing from the bottom plate to connect the bottom plate and the side wall plate. In the concentrator photovoltaic module, the rib may be provided with a rib shielding plate configured to block sunlight concentrated by the condenser lenses from being applied to a side surface of the rib, the rib shielding plate being projected relative to the side surface.
   In this case, by providing the rib shielding plate to the rib which is provided for reinforcement of the housing, it is possible to block concentrated sunlight from being applied to the rib, and it is possible to prevent damage of the rib.
(6) A concentrator photovoltaic panel being one embodiment is formed by arranging a plurality of the concentrator photovoltaic modules according to (1) above.
(7) A concentrator photovoltaic apparatus being one embodiment includes: the concentrator photovoltaic panel according to (5) above; and a driving device configured to drive the concentrator photovoltaic panel so as to operate to track movement of the sun while facing the direction of the sun.

According to the concentrator photovoltaic panel and the concentrator photovoltaic apparatus having the above configurations, costs can be further reduced.

### [Details of embodiment of the present invention]

Hereinafter, preferable embodiments will be described with reference to the drawings.

It should be noted that at least a part of embodiments described below may be combined as desired.

### [Concentrator photovoltaic apparatus and concentrator photovoltaic panel]

First, a configuration of the concentrator photovoltaic apparatus will be described.

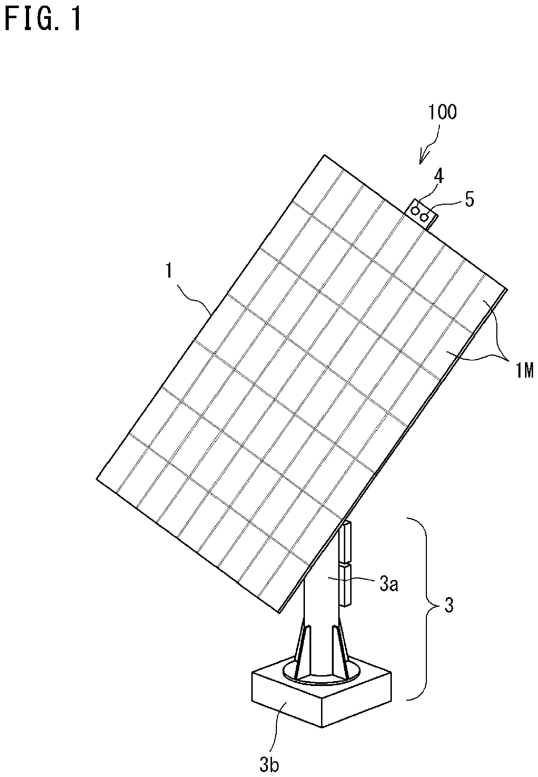

FIG. 1 is a perspective view showing one example of the concentrator photovoltaic apparatus. In FIG. 1, a concentrator photovoltaic apparatus 100 includes: a concentrator photovoltaic panel 1; and a pedestal 3 which includes a post 3a and a base 3b thereof, the post 3a supporting the concentrator photovoltaic panel 1 on the rear surface thereof. The concentrator photovoltaic panel 1 is formed by assembling a large number of concentrator photovoltaic modules 1M vertically and horizontally. In this example, 63 (7 in length × 9 in breadth) concentrator photovoltaic modules 1M are assembled vertically and horizontally. When one concentrator photovoltaic module 1M has a rated output of, for example, about 100 W, the entirety of the concentrator photovoltaic panel 1 has a rated output of about 6 kW.

On the rear surface side of the concentrator photovoltaic panel 1, a driving device (not shown) is provided, and by operating the driving device, it is possible to drive the concentrator photovoltaic panel 1 in two axes of azimuth and elevation. Accordingly, the concentrator photovoltaic panel 1 is driven so as to always face the direction of the sun in both of the azimuth and the elevation. At a place (in this example, an upper end portion) on the concentrator photovoltaic panel 1, or in the vicinity of the panel 1, a tracking sensor 4 and a pyrheliometer 5 are provided. Operation of tracking the sun is performed, relying on the tracking sensor 4 and the position of the sun which is calculated from the time, the latitude, and the longitude of the installation place.

That is, every time the sun has moved by a predetermined angle, the driving device drives the concentrator photovoltaic panel 1 by the predetermined angle. The event that the sun has moved by the predetermined angle may be determined by the tracking sensor 4, or may be determined by the latitude, the longitude, and the time. Thus, there are also cases where the tracking sensor 4 is omitted. The predetermined angle is a constant value, for example, but the value may be changed in accordance with the altitude of the sun and the time.

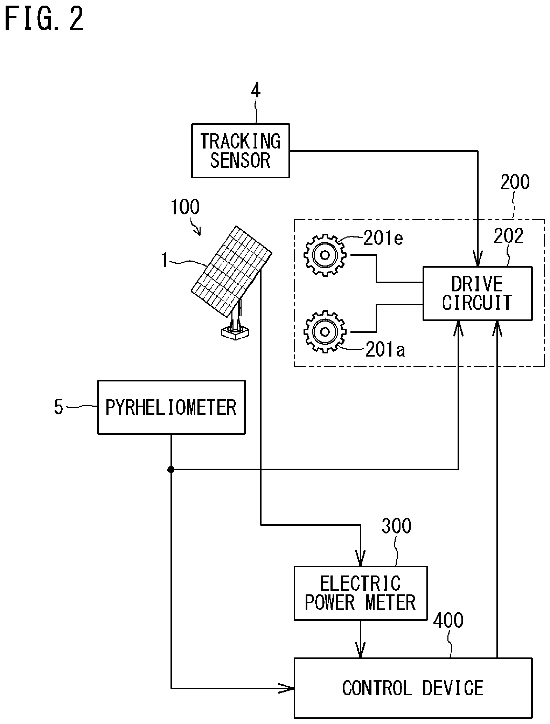

FIG. 2 shows one example of a concentrator photovoltaic system including the driving device and the like. This is a diagram expressed from the viewpoint of tracking operation control. In FIG. 2, as described above, the concentrator photovoltaic apparatus 100 includes a driving device 200 for performing operation of tracking the sun, on the rear surface side thereof, for example. The driving device 200 includes a stepping motor 201e for driving in the elevation direction, a stepping motor 201a for driving in the azimuth direction, and a drive circuit 202 which drives these. It should be noted that the stepping motors are merely examples, and another power source may be used.

An output signal (direct solar irradiance) from the pyrheliometer 5 is inputted to the drive circuit 202 and a control device 400. Generated power of the concentrator photovoltaic panel 1 can be detected by an electric power meter 300, and a signal indicating the detected electric power is inputted to the control device 400. The driving device 200 stores the latitude and the longitude of the installation place of the concentrator photovoltaic panel 1, and also has a function of a clock. Based on an output signal from the tracking sensor 4 and the position of the sun calculated from the latitude, the longitude, and the time, the driving device 200 performs tracking operation such that the concentrator photovoltaic panel 1 always faces the sun. However, as mentioned above, there are cases where the tracking sensor 4 is not provided. In such a case, tracking operation is performed based on only the position of the sun calculated from the latitude, the longitude, and the time.

### [Concentrator photovoltaic module]

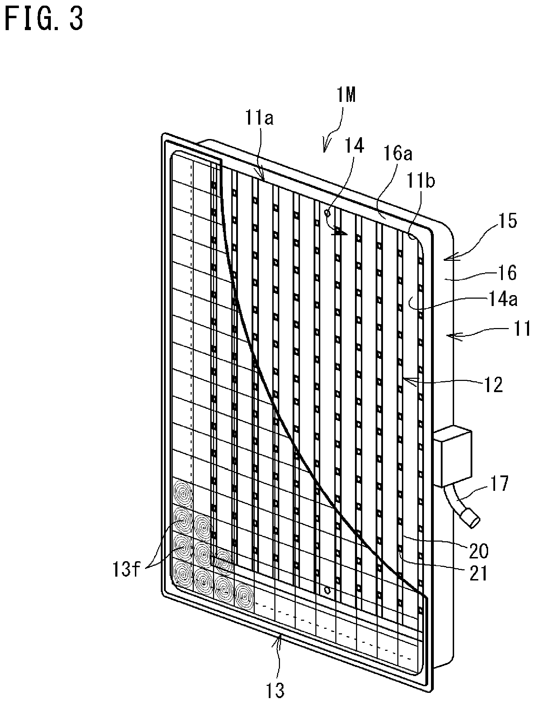

FIG. 3 is a perspective view (partially cut out) showing an enlarged view of one example of the concentrator photovoltaic module (hereinafter, also simply referred to as module) 1M. A shielding plate described later is not shown.

In FIG. 3, the module 1M includes: a housing 11 having a vessel shape; a plurality of flexible printed circuits 12 provided inside the housing 11; and a rectangular (shown in a partially cut out manner) lens panel 13 (concentrating member) closing an open face 11a of the housing 11.

As described above, the housing 11 has the open face 11a on one face thereof, and includes a bottom plate 14 and a frame 15.

The bottom plate 14 is formed in a rectangular shape, by using a metal plate such as an aluminium alloy, for example.

The flexible printed circuits 12 are provided on a bottom surface 14a of the bottom plate 14.

The frame 15 is a member formed by using PBT (poly butylene terephthalate) resin having glass fibers filled therein, for example, and is composed of four side wall plates 16 provided so as to stand along the outer edge of the bottom plate 14. That is, the side wall plates 16 are provided along the entire periphery of the bottom plate 14, and the frame 15 is formed in a rectangular shape.

Distal end edges 16a of the respective side wall plates 16 form an opening 11b which allows the inside of the housing 11 to be open to the outside thereof. Accordingly, the distal end edges 16a of the side wall plates 16 define the open face 11a.

The lens panel 13 is fixed to the distal end edges 16a.

In addition, a connector 17 for taking out the output from the module 1M is provided on one face among the side wall plates 16.

The lens panel 13 is a Fresnel lens array, and is formed by arranging, in a matrix shape, a plurality of (for example, 16 × in length and 12 in breadth, 192 in total) Fresnel lenses 13f as lens elements which concentrate sunlight. Each Fresnel lens 13f forms a square effective concentration region. Such a lens panel 13 can be obtained by forming a silicone resin film on a back surface (inside) of a glass plate used as a base material, for example. Each Fresnel lens 13f is formed on this silicone resin film.

The lens panel 13 is mounted on the distal end edges 16a so as to cover the open face 11a. Accordingly, the lens panel 13 is disposed so as to face the bottom plate 14.

Each flexible printed circuit 12 is obtained by providing a pattern on an elongate flexible printed substrate 20 and by mounting cells (power generating elements) 21 and other electronic components thereon. As the cell 21, a solar cell having heat resistance and high power generation efficiency is used.

It should be noted that using the flexible printed substrate is one example, and another type of substrate may be used. For example, a large number of ceramic substrates or resin substrates each having a flat plate shape (rectangular, etc.) may be used.

In the example shown, each flexible printed circuit 12 has eight cells 21 mounted thereon. The flexible printed circuits 12 are arranged in a plurality of rows along the longitudinal direction of the housing 11, and 24 flexible printed circuits 12 are disposed in total. Thus, the total number of the cells 21 is 192 (24 × 8). Thus, the number of the cells 21 is the same as the number of the Fresnel lenses 13f of the lens panel 13, and further, the cells 21 are provided on the optical axes of their corresponding Fresnel lenses 13f, respectively.

A Fresnel lens 13f and a cell 21 provided so as to correspond to each other form a concentrator photovoltaic unit as an optical system basic unit for a module 1M described above.

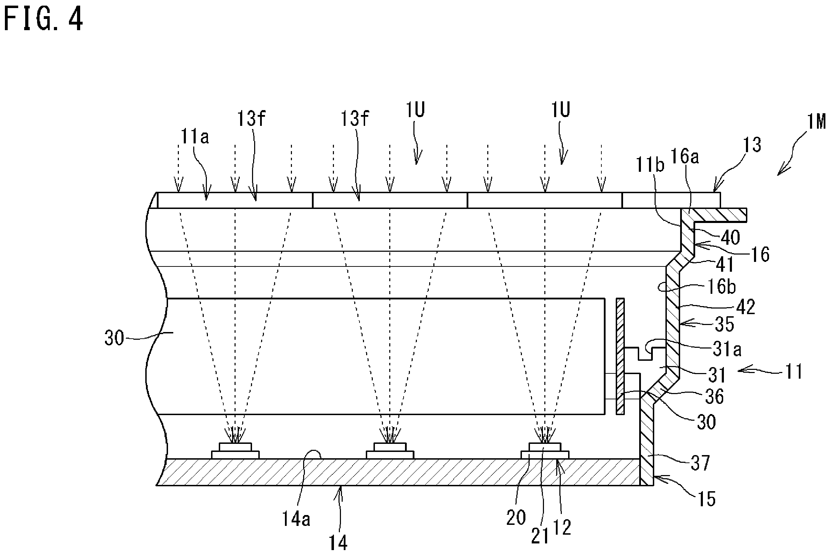

FIG. 4 is a cross-sectional view of a main portion of the module 1M. In FIG. 4, the paths of rays at the time when sunlight is orthogonally incident onto each Fresnel lens 13f are indicated by broken lines.

In FIG. 4, each flexible printed substrate 20 having the cells 21 mounted thereon is fixed to the bottom surface 14a of the bottom plate 14. Thus, the cells 21 are fixed to the bottom plate 14.

As described above, the Fresnel lenses 13f and the cells 21 are in one-to-one correspondence relationship, and sunlight concentrated by each Fresnel lens 13f is applied on its corresponding cell 21. Accordingly, each cell 21 generates power.

That is, a Fresnel lens 13f which is a condenser lens converging sunlight, and a cell 21 which generates power by receiving sunlight converged by the Fresnel lens 13f form a concentrator photovoltaic unit (hereinafter, also referred simply as unit) 1U as an optical system basic unit. Each module 1M is formed by arranging a plurality of units 1U.

In each unit 1U, the cell 21 is disposed near the focal point position of the Fresnel lens 13f. Accordingly, when sunlight is orthogonally incident onto the Fresnel lens 13f, concentrated sunlight is applied to the cell 21.

The driving device 200 (FIG. 2) described above is configured to perform tracking operation with respect to the sun such that the concentrator photovoltaic panel 1 always faces the sun, and performs tracking operation such that sunlight is always orthogonally incident onto the Fresnel lens 13f.

Here, for example, if the driving device 200 stops the tracking operation or the tracking direction is greatly deviated due to some cause, sunlight will be incident from a direction inclined relative to the normal direction of the Fresnel lens 13f.

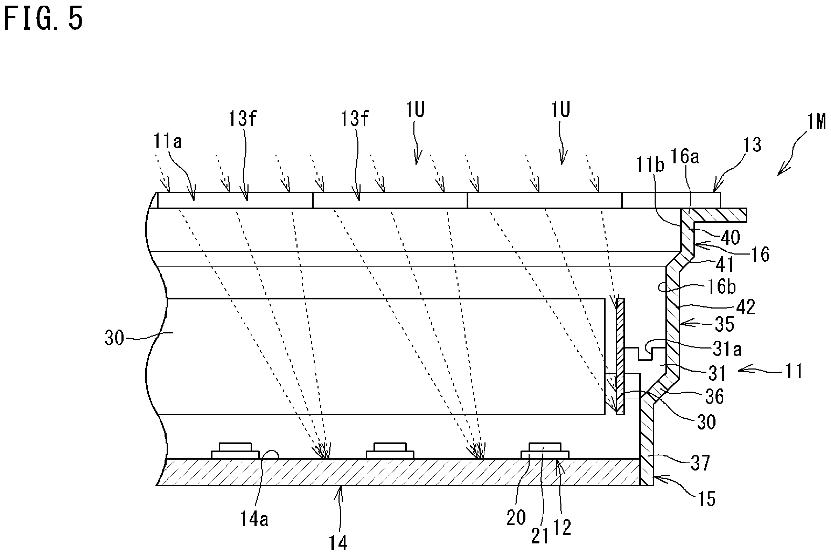

FIG. 5 shows a cross section of the module 1M at the time when sunlight is incident from a direction inclined relative to the normal direction of each Fresnel lens 13f. In FIG. 5, the paths of rays at the time when sunlight is incident from a direction inclined relative to the normal direction of the Fresnel lens 13f are indicated by broken lines.

In this case, in the housing 11, the ray axis of sunlight having passed through the Fresnel lens 13f also becomes inclined, and thus, positional displacement occurs in the sunlight-concentrated part. Thus, the sunlight having passed through the Fresnel lens 13f is not concentrated on the cell 21 but is concentrated on another part in the housing 11.

In particular, in some cases, sunlight having passed through a Fresnel lens 13f that is located at an end portion of the lens panel 13 and thus is disposed near a side wall plate 16 is concentrated toward the side wall plate 16.

Therefore, the module 1M of the present embodiment includes, inward from the frame 15, shielding plates 30 which block sunlight concentrated by the Fresnel lenses 13f from being applied to the inner side-surfaces of the side wall plates 16.

### [Shielding plate]

Each shielding plate 30 is a member having an elongate rectangular plate shape and extending in parallel to the lens panel 13 along its corresponding side wall plate 16. One shielding plate 30 is provided for each of the four side wall plates 16 forming the frame 15. Each shielding plate 30 is disposed, having a predetermined interval from an inner side-surface 16b of its corresponding side wall plate 16. Accordingly, the shielding plate 30 is provided so as to project further inward relative to the housing 11 than the inner side-surface 16b.

In addition, the shielding plate 30 is provided so as to be substantially perpendicular to the bottom plate 14.

The shielding plate 30 is fixed to the frame 15 by a support portion 31 provided so as to protrude inward relative to the frame 15, from the inner side-surface 16b of the side wall plate 16.

A plurality of the support portions 31 are provided at predetermined intervals along the longitudinal direction of the shielding plate 30, and couple the shielding plate 30 to the side wall plate 16.

The shielding plate 30 is formed from the same material (PBT resin having glass fibers filled therein) as the frame 15, and is formed integrally with the plurality of the support portions 31 and the side wall plate 16.

Thus, the shielding plate 30 can be formed at the same time as the frame 15 is formed.

The shielding plate 30 is provided slightly closer to the bottom plate 14 in the height direction of the side wall plate 16. The shielding plate 30 are dimensioned so as to be able to block sunlight having passed through the Fresnel lens 13f, from being applied to a region that extends from a proximal end portion on the bottom plate 14 side of the side wall plate 16 to substantially the center in the height direction of the side wall plate 16.

Accordingly, when sunlight is incident from a direction inclined relative to the normal direction of the Fresnel lens 13f, sunlight concentrated toward the vicinity of the end portion on the bottom plate 14 side of the side wall plate 16 is prevented from being applied.

Sunlight that is applied to a region extending above substantially the center in the height direction of the side wall plate 16 is not so concentrated as to damage the side wall plate 16, because the distance from the Fresnel lens 13f to the side wall plate 16 is sufficiently shorter than the focal length.

With respect to the region that is shielded by the shielding plate 30 and that extends from the proximal end portion on the bottom plate 14 side of the side wall plate 16 to substantially the center in the height direction of the side wall plate 16, the distance from the Fresnel lens 13f to the side wall plate 16 is comparatively close to the focal length, and thus, there is a risk that sunlight is concentrated to damage the side wall plate 16.

The shielding plate 30 blocks concentrated sunlight, which may damage the side wall plate 16 as described above, from being applied to the inner side-surface 16b of the side wall plate 16, and thus prevents the side wall plate 16 from being damaged.

In other words, the shielding plate 30 is projected inward relative to the housing 11, at a position where sunlight before being sufficiently concentrated is applied. Thus, the shielding plate 30 receives sunlight before the sunlight reaching the inner side-surface 16b of the side wall plate 16, thereby preventing the side wall plate 16 from being damaged.

As described above, the shielding plate 30 is formed from the same material (PBT resin having glass fibers filled therein) as the frame 15. That is, the shielding plate 30 is a member made of the same material as the side wall plate 16, and thus, could be damaged if concentrated sunlight is applied thereto. However, the shielding plate 30 is disposed between the lens panel 13 and the bottom plate 14, and is provided so as to project inward relative to the frame 15. Thus, the distance from the shielding plate 30 to the Fresnel lens 13f is sufficiently shorter than the focal length. Therefore, sunlight before being concentrated is applied to the shielding plate 30. Thus, the shielding plate 30 is not damaged even if sunlight is applied thereto.

### [Frame]

The frame 15 includes: a first frame body 35 whose one end forms the open face 11a; and a second frame body 37 being on the bottom plate 14 side and being connected to the other end of the first frame body 35 via an inclined portion 36.

The first frame body 35 has a rectangular frame shape and is composed of four side wall plates. The second frame body 37 also has a rectangular frame shape and is composed of four side wall plates.

Each side wall plate 16 of the frame 15 is formed by connecting a side wall plate of the first frame body 35 and a side wall plate of the second frame body 37.

The first frame body 35 includes the distal end edges 16a of the side wall plates 16, the distal end edges 16a defining the open face 11a.

The first frame body 35 includes: distal end portions 40 respectively extending from the distal end edges 16a; shoulder portions 41 respectively projecting slightly inward relative to the frame 15 from the distal end portions 40; and body portions 42 respectively being connected to the shoulder portions 41.

The distal end edges 16a form a flange shape, and has the lens panel 13 fixed thereto.

The body portions 42 connected from the distal end portions 40 via the shoulder portions 41 are formed such that the inner dimension of the inside space of the rectangular shape formed by the body portions 42 is greater than the outer dimension of the rectangular shape of the second frame body 37. Therefore, the second frame body 37 can be inserted into the inside space formed by the body portions 42.

That is, the first frame body 35 is formed to have dimensions that allow the second frame body 37 to be inserted inside the first frame body 35.

Thus, one frame 15 as a component before being assembled into a module 1M can be combined with another frame 15, by inserting, through the opening 11b into the first frame body 35 of the one frame 15, the second frame body 37 of the another frame 15.

The plurality of the support portions 31 are configured such that: when into the first frame body 35 of one frame 15, the second frame body 37 of another frame 15 is inserted and the frames 15 are combined with each other, the plurality of the support portions 31 abut against a tip portion 37a of the second frame body 37 of the another frame 15 to hold the another frame 15 in the height direction.

Further, a positioning portion 31a for holding and positioning the tip portion 37a of the second frame body 37 of another frame 15 is formed at the end surface on the open face 11a side of each support portion 31. Each positioning portion 31a is formed in a recessed shape obtained by cutting off a portion of the end surface on the open face 11a side of the support portion 31. When the tip portion 37a is inserted in the positioning portion 31a, the positioning portion 31a holds and positions the tip portion 37a (another frame 15).

In a case where there are a plurality of the frames 15 configured as described above, by inserting, into the first frame body 35 of one frame 15, the second frame body 37 of another frame 15 up to a position where the second frame body 37 of the another frame 15 abuts against the plurality of the support portions 31, the one frame 15 and the another frame 15 can be combined with each other. Thus, by inserting portions of the plurality of the frames 15 into one another, the plurality of the frames 15 can be combined with one another and can be sequentially stacked with one another.

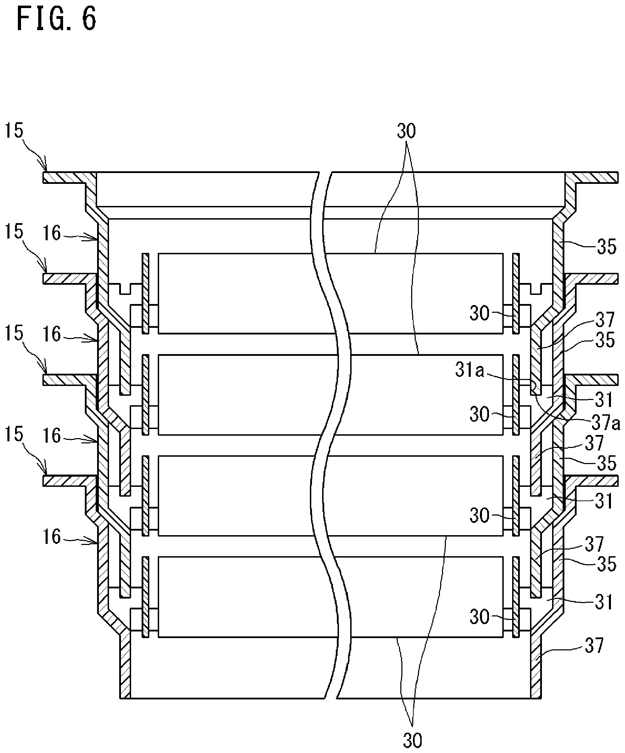

FIG. 6 is a cross-sectional view of a main portion of a plurality of the frames 15 having been stacked.

As shown in FIG. 6, into the first frame body 35 of each of the frames 15 stacked in the up-down direction, the second frame body 37 of another frame 15 is inserted from the open face 11a up to a position where the second frame body 37 of the another frame 15 abuts against the support portions 31.

At this time, the tip portion 37a of the second frame body 37 has been inserted into the positioning portion 31a of each support portion 31. Accordingly, positional displacement between the frames 15 combined with each other can be prevented, and thus, the frames 15 can be combined stably. As a result, the stability of the plurality of the frames 15 having been stacked can be increased.

As shown in FIG. 6, each frame 15 can, by inserting the second frame body 37 being a portion thereof into another frame 15, be combined with the another frame 15, and the frames 15 can be sequentially stacked with one another.

Accordingly, for example, compared with a case where frames that cannot be combined by inserting a portion thereof into another frame are stacked, the space occupied by a plurality of frames having been stacked can be reduced.

Although the frame 15 described above has a shape obtained by connecting the first frame body 35 and the second frame body 37, this frame 15 has a shape that allows the die for forming the frame 15 to have a structure, for example, in which the die is separated in the up-down direction on the drawing sheet to take out the formed frame 15.

That is, the frame 15 can be formed by using a die having a simple structure in which the die is separated in the up-down direction.

### [Effects]

The module 1M having the above configuration includes: the housing 11 having the open face 11a on one face thereof; a plurality of cells 21 each being a power generating element, the plurality of cells 21 being provided in a form of an array on the bottom surface 14a of the bottom plate 14 of the housing 11; and the lens panel 13 being a concentrating member, being mounted on the housing 11 so as to cover the open face 11a, being disposed so as to face the bottom plate 14, and being composed of a plurality of Fresnel lenses 13f formed at positions corresponding to the cells 21 on respective optical axes of the Fresnel lenses 13f, the Fresnel lenses 13f each being a condenser lens for concentrating sunlight, wherein the housing 11 includes the frame 15 composed of side wall plates 16 which are formed from resin and which are provided so as to stand along the outer edge of the bottom plate 14, and inward from the frame 15, the shielding plates 30 configured to block sunlight concentrated by the Fresnel lenses 13f from being applied to the inner side-surfaces 16b of the side wall plates 16 are provided so as to project inward relative to the inner side-surfaces 16b.

According to the module 1M having the above configuration, the shielding plates 30 which block sunlight from being applied to the inner side-surfaces 16b of the side wall plates 16 are provided so as to project inward relative to the inner side-surfaces 16b. Therefore, unlike the conventional example described above, in order to block sunlight, the frame 15 need not be formed in a complicated shape obtained by bringing a pair of frame bodies each having a truncated quadrangular pyramid shape into contact with each other. Therefore, the frame 15 can have a shape that can simplify the structure of the die for forming the frame 15. Specifically, a die to be pulled out in two directions can be employed. As a result, it is possible to suppress production cost of the frame 15, and it is possible to realize low cost for the entire module 1M, and to prevent damage of the housing 11 even when positional displacement has occurred in the sunlight-concentrated part.

As described above, according to the module 1M, each frame 15 can, by inserting the second frame body 37 being a portion thereof into another frame 15, be combined with the another frame 15, and the frames 15 can be sequentially stacked with one another. Thus, the space occupied by a plurality of the frames 15 having been stacked can be reduced. Accordingly, when producing the module 1M, it is possible to reduce the space necessary for storage and transportation of a large number of the frames 15, and further, it is possible to reduce costs.

### [Other embodiments]

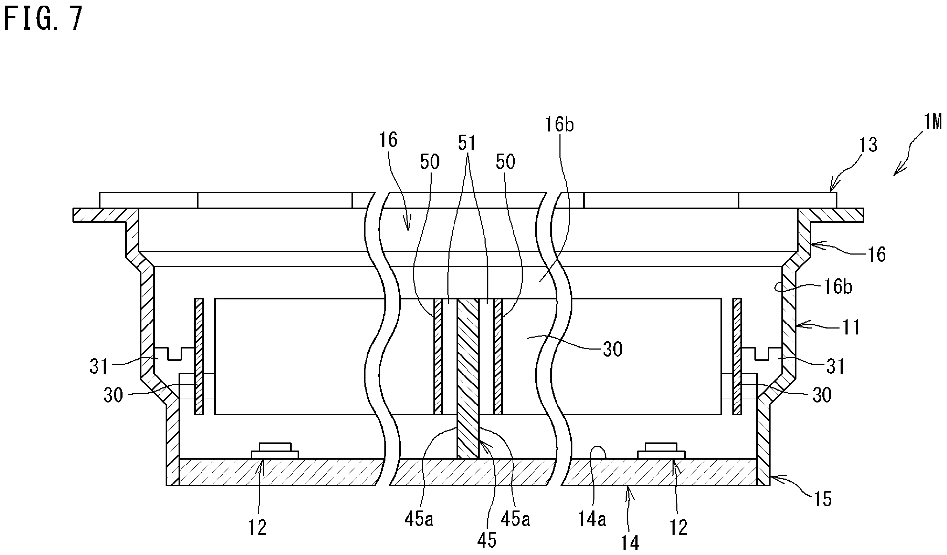

FIG. 7 is a cross-sectional view of a main portion of a concentrator photovoltaic module according to another embodiment.

A module 1M according to this embodiment is different from the module 1M according to the above embodiment, in that the module 1M according to this embodiment has a rib 45 provided so as to cross substantially the center of the inside of the housing 11.

The rib 45 is a plate-shaped member provided so as to stand from the bottom surface 14a of the bottom plate 14. Opposite end portions of the rib 45 are fixed to the inner side-surfaces 16b of a pair of side wall plates 16 that face each other. Thus, the rib 45 connects the pair of side wall plates 16 with each other, and connects the bottom plate 14 and the pair of side wall plates 16. Thus, the rib 45 has a function as a reinforcement member for increasing the strength of the housing 11, and can ensure the strength against wind load from the back surface of the housing 11 in particular.

For example, the rib 45 is formed from the same material (PBT resin having glass fibers filled therein) as the side wall plates 16, or the like, and is fixed to the bottom plate 14 and the pair of side wall plates 16 by means of screws or adhesive.

Since the rib 45 is provided so as to stand from the bottom plate 14 inside the housing 11, concentrated sunlight could be applied to the rib 45, as in the case of the side wall plates 16. Therefore, also for side surfaces 45a of the rib 45, rib shielding plates 50 for blocking concentrated sunlight from being applied to the side surface 45a of the rib 45 are provided, respectively. The rib shielding plates 50 are each a member having an elongate rectangular plate shape extending along the rib 45 in parallel to the lens panel 13. The rib shielding plates 50 are provided on both side surfaces 45a of the rib 45, respectively. Each rib shielding plate 50 is disposed, having a predetermined interval from its corresponding side surface 45a of the rib 45. Thus, each rib shielding plate 50 is provided so as to project relative to its corresponding side surface 45a.

Each rib shielding plate 50 is fixed to the rib 45 by a support portion 51 provided so as to protrude from its corresponding side surface 45a of the rib 45.

The rib shielding plate 50 is formed from the same material (PBT resin having glass fibers filled therein) as the rib 45, and is formed integrally with the rib 45.

Opposite end surfaces of the rib shielding plate 50 are in contact with the shielding plates 30 respectively provided for a pair of side wall plates 16 connected by the rib 45.

In the present embodiment, the rib shielding plates 50 are provided to the rib 45 which is provided for reinforcement of the housing 11. Therefore, it is possible to block concentrated sunlight from being applied to the rib 45, and it is possible to prevent damage of the rib 45.

### [Others]

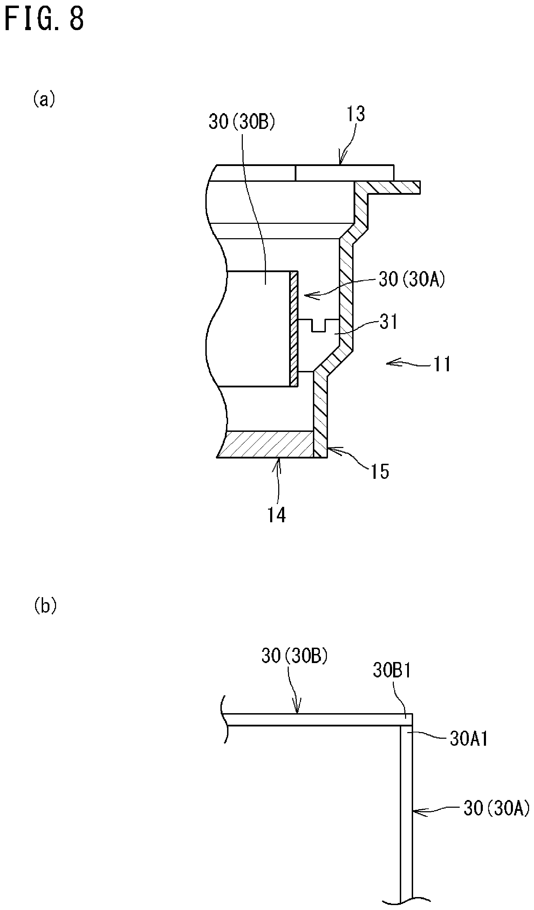

The present invention is not limited to the above embodiments. In each embodiment described above, an exemplary case has been shown in which: the shielding plates 30 for the respective side wall plates 16 are provided, having a gap between end portions of the shielding plates 30 adjacent to each other. However, for example, the shielding plates 30 may be provided such that end portions of the shielding plates 30 adjacent to each other are in contact with each other, as shown in FIG. 8.

FIG. 8(a) is a cross-sectional view of a main portion of a concentrator photovoltaic module according to a modification. FIG. 8(b) shows only the shielding plates 30 at the time when the concentrator photovoltaic module shown in FIG. 8(a) is viewed from the open face 11a side.

As shown in FIG. 8(a) and FIG. 8(b), in this modification, an end portion 30A1 of a shielding plate 30A and an end portion 30B1 of a shielding plate 30B are in contact with each other.

The end portions 30A1 and 30B1 are fixed and connected to each other by means of screws, adhesive, or the like.

As in this modification, if the end portions of the shielding plates 30 adjacent to each other are brought into contact with each other, concentrated sunlight can be prevented from entering through the gap between the shielding plates 30, and thus, four corners of the housing 11 can be prevented from being damaged.

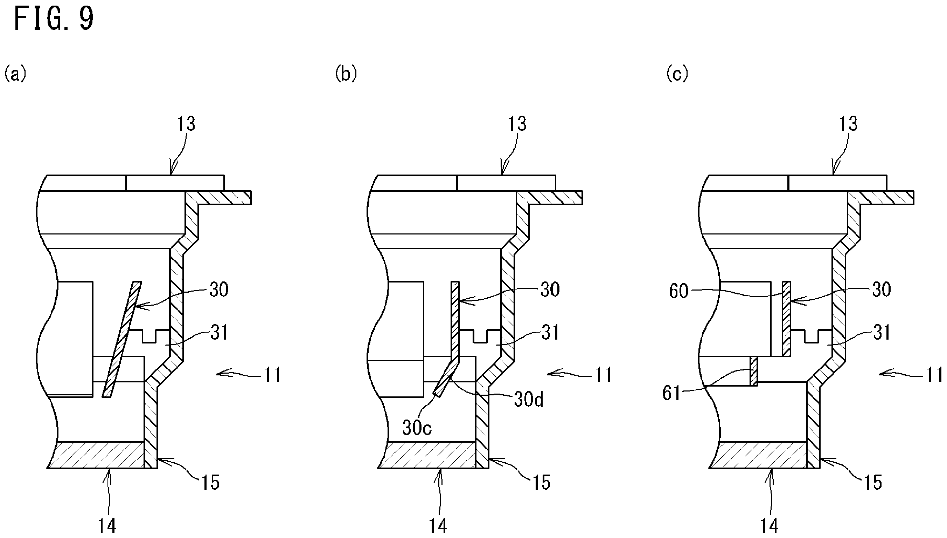

In each embodiment described above, an exemplary case has been shown in which: the shielding plates 30 are provided so as to be substantially perpendicular to the bottom plate 14. However, the shielding plates 30 may be disposed with an angle relative to the bottom plate 14, as shown in FIG. 9(a), for example. The angle of each shielding plate 30 in this case can be set as appropriate in accordance with the configuration of the housing 11 and how sunlight is incident.

In each embodiment described above, an exemplary case has been shown in which the shielding plate 30 is formed in a flat plate shape. However, as shown in FIG. 9(b), the shielding plate 30 may have a shape in which a portion thereof is bent. Alternatively, as shown in FIG. 9(c), a configuration may be employed in which a plurality of shielding plates are combined.

In FIG. 9(b), a bent portion 30d is provided such that a lower end portion 30c of the shielding plate 30 is located to the inward side of the housing 11.

Thus, by providing the bent portion 30d, the degree of freedom of how to shield sunlight can be increased, and the shielding plate 30 can be provided such that sunlight can be shielded in a preferable manner in accordance with the configuration or the like of the housing 11.

In FIG. 9(c), the shielding plate 30 is composed of: a first shielding plate 60; and a second shielding plate 61 disposed lower than the first shielding plate 60 and disposed further inward relative to the housing 11 than the first shielding plate 60.

Also in this case, since the shielding plate 30 is composed of the first shielding plate 60 and the second shielding plate 61, the degree of freedom of how to shield sunlight can be increased, and the shielding plate 30 can be provided such that sunlight can be shielded in a preferable manner in accordance with the configuration or the like of the housing 11.

In each embodiment described above, a case has been shown in which the positioning portion 31a is formed in a recessed shape obtained by cutting off a portion of the end surface on the open face 11a side of the support portion 31. However, it is sufficient that the positioning portion 31a can hold and position the tip portion 37a of the second frame body 37 of another frame 15. Thus, a projecting portion for holding the tip portion 37a may be provided on the end surface on the open face 11a side of the support portion 31, and the projecting portion may be used as the positioning portion 31a.

In each embodiment described above, an exemplary case has been shown in which: a plurality of the support portions 31 are provided at predetermined intervals along the longitudinal direction of the shielding plate 30. However, one support portion 31 may be provided for each side wall plate 16, and each shielding plate 30 may be fixed to the frame 15 by means of the one support portion 31.

In the embodiments described above, an exemplary case has been shown in which: the frame 15 is composed of: the first frame body 35; and the second frame body 37 having an outer dimension different from that of the first frame body 35. However, as long as the shielding plates 30, which are each formed so as to be able to block sunlight having passed through the Fresnel lens 13f from being applied, are provided so as to project inward relative to the inner side-surface 16b, and as long as the shape of the frame 15 can simplify the structure of the die for forming the frame 15, the shape of the frame 15 is not limited to the shape of the above embodiments.

In the above embodiments, an exemplary case has been shown in which: each shielding plate 30 is formed integrally with the support portions 31 and the side wall plate 16.

In the above embodiments, an exemplary case has been shown in which: the frame 15 and each shielding plate 30 are formed with PBT resin having fibers filled therein. However, another resin can be used as long as the resin has appropriate heat resistance and necessary strength.

### [Ending]

It should be noted that the embodiment disclosed herein is merely illustrative in all aspects and should not be recognized as being restrictive. The scope of the present invention is defined by the scope of the claims rather than by the meaning described above, and is intended to include all modifications within the scope.

### REFERENCE SIGNS LIST

- 1: concentrator photovoltaic panel
- 1M: concentrator photovoltaic module
- 1U: concentrator photovoltaic unit
- 3: pedestal
- 3a: post
- 3b: base
- 4: tracking sensor
- 5: pyrheliometer
- 11: housing
- 11a: open face
- 11b: opening
- 12: flexible printed circuit
- 13: lens panel (concentrating member)
- 13f: Fresnel lens (condenser lens)
- 14: bottom plate
- 14a: bottom surface
- 15: frame
- 16: side wall plate
- 16a: distal end edge
- 16b: inner side-surface
- 17: connector
- 20: flexible printed substrate
- 21: cell (power generating element)
- 30, 30A, 30B: shielding plate
- 30A1: end portion
- 30B1: end portion
- 30c: lower end portion
- 30d: bent portion
- 31: support portion
- 31a: positioning portion
- 35: first frame body
- 36: inclined portion
- 37: second frame body
- 37a: tip portion
- 40: distal end portion
- 41: shoulder portion
- 42: body portion
- 45: rib
- 45a: side surface
- 50: rib shielding plate
- 51: support portion
- 60: first shielding plate
- 61: second shielding plate
- 100: concentrator photovoltaic apparatus
- 200: driving device
- 201e: stepping motor
- 201a: stepping motor
- 202: drive circuit
- 300: electric power meter
- 400: control device
- 500: first die
- 501: second die
- 502: third die

## Claims

1. A concentrator photovoltaic module (1M) comprising:
a housing (11) having an open face (11a) on one face thereof;
a plurality of power generating elements (21) provided in a form of an array on a bottom plate (14) of the housing (11); and
a concentrating member (13) being mounted on the housing (11) so as to cover the open face (11a), being disposed so as to face the bottom plate (14), and being composed of a plurality of condenser lenses (13f) for concentrating sunlight, the condenser lenses (13f) formed at positions corresponding to the power generating elements (21) on respective optical axes of the condenser lenses (13f), wherein
the housing (11) includes a frame (15) composed of a resin side wall plate (16) provided so as to stand along an outer edge of the bottom plate (14),
inward from the frame (15), a shielding plate (30) configured to block sunlight concentrated by the condenser lenses (13f) from being applied to an inner side-surface (16b) of the side wall plate (16) is provided so as to project inward relative to the inner side-surface (16b), and
the shielding plate (30) is coupled to the side wall plate (16) by a support portion (31) provided so as to protrude from the inner side-surface (16b), **characterized in that** said shielding plate (30) is formed integrally with the support portion (31) and the side wall plate (16).

2. The concentrator photovoltaic module (1M) according to claim 1, wherein
the frame (15) includes:
a first frame body (35) whose one end forms the open face (11a); and
a second frame body (37) being on the bottom plate side and being connected to another end of the first frame body (35),
the first frame body (35) is formed to have dimensions that allow the second frame body (37) to be inserted inside the first frame body (35), and
when a second frame body (37) forming another frame is inserted into the first frame body (35), the support portion (31) abuts against the second frame body (37) forming the another frame to hold the another frame in a height direction of the frame (15).

3. The concentrator photovoltaic module (1M) according to claim 2, wherein
a positioning portion (31a) configured to position a tip portion of the second frame body (37) of the another frame is formed in the support portion (31).

4. The concentrator photovoltaic module (1M) according to any one of claim 1 to claim 3, further comprising
a rib (45) being disposed in the housing (11) and standing from the bottom plate (14) to connect the bottom plate (14) and the side wall plate (16), wherein
the rib (45) is provided with a rib shielding plate (50) configured to block sunlight concentrated by the condenser lenses (13f) from being applied to a side surface of the rib (45), the rib shielding plate (50) being projected relative to the side surface.

5. A concentrator photovoltaic panel (1) formed by arranging a plurality of the concentrator photovoltaic modules (1M) according to claim 1.

6. A concentrator photovoltaic apparatus (100) comprising:
the concentrator photovoltaic panel (1) according to claim 5; and
a driving device (200) configured to drive the concentrator photovoltaic panel (1) so as to operate to track movement of the sun while facing the direction of the sun.

## Patentansprüche

1. Konzentrator-Photovoltaikmodul (1M), umfassend:
ein Gehäuse (11), das auf einer Seite eine offene Fläche (11a) aufweist,
eine Vielzahl von Stromerzeugungselementen (21), die in der Form einer Matrix an einer Bodenplatte (14) des Gehäuses (11) vorgesehen sind, und
ein Konzentrationsglied (13), das an dem Gehäuse (11) derart montiert ist, dass es die offene Fläche (11a) bedeckt, derart angeordnet ist, dass es der Bodenplatte (14) zugewandt ist, und aus einer Vielzahl von Kondensorlinsen (13f) für das Konzentrieren von Sonnenlicht besteht, wobei die Kondensorlinsen (13f) an Positionen in Entsprechung zu den Stromerzeugungselementen (21) auf entsprechenden optischen Achsen der Kondensorlinsen (13f) ausgebildet sind,
wobei das Gehäuse (11) einen Rahmen (15) umfasst, der aus einer Kunstharz-Seitenwandplatte (16) besteht, die derart vorgesehen ist, dass sie sich entlang einer Außenkante der Bodenplatte (14) erhebt,
innerhalb des Rahmens (15) eine Abschirmungsplatte (30), die konfiguriert ist zum Verhindern, dass durch die Kondensorlinsen (13f) konzentriertes Sonnenlicht auf eine Innenseitenfläche (16b) der Seitenwandplatte (16) einfällt, derart vorgesehen ist, dass sie relativ zu der Innenseitenfläche (16b) nach innen vorsteht, und
die Abschirmungsplatte (30) mit der Seitenwandplatte (16) durch einen Halteteil (31) gekoppelt ist, der derart vorgesehen ist, dass er von der Innenseitenfläche (16b) nach innen vorsteht,
**dadurch gekennzeichnet, dass** die Abschirmungsplatte (30) einstückig mit dem Halteteil (31) und dem Seitenwandteil (16) ausgebildet ist.

2. Konzentrator-Photovoltaikmodul (1M) nach Anspruch 1, wobei der Rahmen (15) umfasst:
einen ersten Rahmenkörper (35), dessen eines Ende die offene Fläche (11a) bildet, und
einen zweiten Rahmenkörper (37), der auf der Seite der Bodenplatte vorgesehen ist und mit einem anderen Ende des ersten Rahmenkörpers (35) verbunden ist,
wobei der erste Rahmenkörper (35) mit Dimensionen ausgebildet ist, die erlauben, dass der zweite Rahmenkörper (37) in den ersten Rahmenkörper (35) eingesteckt wird, und
wobei, wenn ein zweiter Rahmenkörper (37), der einen anderen Rahmen bildet, in den ersten Rahmenkörper (35) eingesteckt wird, der Halteteil (31) gegen den zweiten Rahmenkörper (37), der den anderen Rahmen bildet, anstößt, um den anderen Rahmen in einer Höhenrichtung des Rahmens (15) zu halten.

3. Konzentrator-Photovoltaikmodul (1M) nach Anspruch 2, wobei:
ein Positionierungsteil (31a), der konfiguriert ist zum Positionieren eines Endteils des zweiten Rahmenkörpers (37) des anderen Rahmens, in dem Halteteil (31) ausgebildet ist.

4. Konzentrator-Photovoltaikmodul (1M) nach einem der Ansprüche 1 bis 3, das weiterhin umfasst:
eine Rippe (45), die in dem Gehäuse (11) angeordnet ist und sich von der Bodenplatte (14) erhebt, um die Bodenplatte (14) mit der Seitenwandplatte (16) zu verbinden,
wobei die Rippe (45) mit einer Rippenabschirmungsplatte (50) versehen ist, die konfiguriert ist zum Verhindern, dass durch die Kondensorlinsen (13f) konzentriertes Sonnenlicht auf eine Seitenfläche (16b) der Rippe (45) einfällt, wobei die Rippenabschirmungsplatte (50) relativ zu der Seitenfläche vorsteht.

5. Konzentrator-Photovoltaikpanel (1), das durch das Anordnen einer Vielzahl von Konzentrator-Photovoltaikmodulen (1M) gemäß dem Anspruch 1 gebildet wird.

6. Konzentrator-Photovoltaikvorrichtung (100) umfassend:
das Konzentrator-Photovoltaikpanel (1) gemäß dem Anspruch 5, und
eine Antriebsvorrichtung (200), die konfiguriert ist zum Antreiben des Konzentrator-Photovoltaikpanels (1), damit dieses für eine Verfolgung der Sonnenbewegung in einer Ausrichtung zu der Sonne betrieben wird.

## Revendications

1. Module photovoltaïque concentrateur (1M) comprenant :
un boîtier (11) présentant une face ouverte (11a) sur une face de celui-ci ;
plusieurs éléments produisant de l'énergie (21) fournis dans une forme d'une rangée sur une plaque de fond (14) du boîtier (11) ; et
un élément concentrant (13) étant fixé sur le boîtier (11) afin de recouvrir la face ouverte (11a), étant disposé afin de faire face à la plaque de fond (14), et étant constitué de plusieurs lentilles convergentes (13f) pour concentrer la lumière du soleil, les lentilles convergentes (13f) formées à des positions correspondant aux éléments de production d'énergie (21) sur des axes optiques respectifs des lentilles convergentes (13f), dans lequel
le boîtier (11) inclut un cadre (15) constitué d'une plaque de paroi latérale de résine (16) fournie afin de se tenir le long d'un bord externe de la plaque de fond (14),
vers l'intérieur à partir du cadre (15), une plaque d'écran (30) configurée pour bloquer l'application de lumière du soleil concentrée par les lentilles convergentes (13f) sur une surface latérale interne (16b) de la plaque de paroi latérale (16) est fournie afin de faire saillie vers l'intérieur par rapport à la surface latérale interne (16b), et
la plaque d'écran (30) est couplée à la plaque de paroi latérale (16) par une portion de support (31) fournie afin de faire saillie à partir de la surface latérale interne (16b), **caractérisé en ce que** ladite plaque d'écran (30) est formée en une pièce avec la portion de support (31) et la plaque de paroi latérale (16).

2. Module photovoltaïque concentrateur (1M) selon la revendication 1, dans lequel
le cadre (15) inclut :
un premier corps de cadre (35) dont une extrémité forme la face ouverte (11a); et
un second corps de cadre (37) se trouvant sur le côté de plaque de fond et étant connecté à une autre extrémité du premier corps de cadre (35),
le premier corps de cadre (35) est formé pour présenter des dimensions qui permettent au second corps de cadre (37) d'être inséré à l'intérieur du premier corps de cadre (35), et
lorsqu'un second corps de cadre (37) formant un autre cadre est inséré dans le premier corps de cadre (35), la portion de support (31) bute contre le second corps de cadre (37) formant l'autre cadre pour supporter l'autre cadre dans une direction de hauteur du cadre (15).

3. Module photovoltaïque concentrateur (1M) selon la revendication 2, dans lequel
une portion de positionnement (31a) configurée pour positionner une portion d'extrémité du second corps de cadre (37) de l'autre cadre est formée dans la portion de support (31).

4. Module photovoltaïque concentrateur (1M) selon l'une quelconque des revendications 1 à 3, comprenant de plus
une nervure (45) étant disposée dans le boîtier (11) et se tenant à partir de la plaque de fond (14) pour connecter la plaque de fond (14) et la plaque de paroi latérale (16), dans lequel
la nervure (45) est munie d'une plaque d'écran de nervure (50) configurée pour bloquer l'application de lumière du soleil concentrée par les lentilles convergentes (13f) sur une surface latérale de la nervure (45), la plaque d'écran de nervure (50) faisant saillie par rapport à la surface latérale.

5. Panneau photovoltaïque concentrateur (1) formé en arrangeant plusieurs modules photovoltaïques concentrateurs (1M) selon la revendication 1.

6. Appareil photovoltaïque concentrateur (100) comprenant :
le panneau photovoltaïque concentrateur (1) selon la revendication 5 ; et
un dispositif de commande (200) configuré pour commander le panneau photovoltaïque concentrateur (1) afin d'opérer un mouvement de capture du soleil tout en faisant face à la direction du soleil.
